Europäisches Patentamt

European Patent Office

Office européen des brevets

(19)

(11) Publication number: **0 228 129**
**B1**

# EUROPEAN PATENT SPECIFICATION

(12)

(45) Date of publication of the patent specification:
31.10.90

(51) Int. Cl.⁵: **G01N 24/08**

(21) Application number: **86202250.6**

(22) Date of filing: **12.12.86**

(54) Magnetic resonance imaging (MRI) method and device for reducing movement artefacts.

(30) Priority: **20.12.85 NL 8503525**

(43) Date of publication of application:
**08.07.87 Bulletin 87/28**

(45) Publication of the grant of the patent:
**31.10.90 Bulletin 90/44**

(84) Designated Contracting States:
**BE DE FR GB IT NL SE**

(56) References cited:
**EP-A- 0 127 850**
**EP-A- 0 132 975**
**DE-A- 3 421 045**
**US-A- 4 567 893**

**AMERICAN JOURNAL OF RADIOLOGY, vol. 143,
December 1984, pages 1175-1182, American Roentgen
Ray Society, New York, US; R.L. EHMAN et al.:
"Magnetic resonance imaging with respiratory gating:
Techniques and advantages"
MEDICAL PHYSICS, vol. 12, no. 2, March/April 1985,
pages 143-151, American Assoc. Phys. Med., New York,
US; M.L. WOOD et al.: "MR image artifacts from
periodic motion"
Book of Abstract, vol. 1, Categories 1-10 (1985),
Yamashita et al, pp. 1064-1065**

(73) Proprietor: **N.V. Philips' Gloeilampenfabrieken,
Groenewoudseweg 1, NL-5621 BA Eindhoven(NL)**

(72) Inventor: **Cuppen, Johannes J. M. c/oInt. Octrooibureau
B.V., Prof. Holstlaan 6, NL-5656 AA Eindhoven(NL)**

(74) Representative: **Zwaan, Andries Willem et al,
INTERNATIONAAL OCTROOIBUREAU B.V. Prof.
Holstlaan 6, NL-5656 AA Eindhoven(NL)**

## Description

The invention relates to a method of determining a nuclear magnetization distribution in a region of a body which is situated in a steady uniform magnetic field and in which a spin resonance signal is generated by means of an r.f. electromagnetic pulse, the spin resonance signal being prepared by means of a magnetic preparation gradient superimposed on the uniform magnetic field and being measured by means of a magnetic measurement gradient superimposed on the uniform magnetic field, which measurement is repeated a number of times using different, predetermined values of the time integral of the preparation gradient, predetermined values of the time integral being used for predetermined time shifts with respect to a reference point of time of a substantially periodic movement of the region of the body.

The invention also relates to a device for determining a nuclear magnetization distribution in a region of a body, which device comprises:

a) means for applying a steady, uniform magnetic field,

b) means for exciting an r.f. electromagnetic pulse,

c) means for applying a magnetic preparation gradient field during a preparation period,

d) means for applying a magnetic measurement gradient field during a measurement period,

e) sampling means for sampling, during the measurement period, a resonance signal excited by the r.f. electromagnetic pulse,

f) processing means for processing the signals supplied by the sampling means, and

g) control means for controlling said means in the paragraphs b) up to and including f), the control means supplying said means in paragraph c) with control signals for adjusting the time integral of the magnetic preparation gradient, predetermined values of the time integral being used for predetermined time shifts with respect to a reference point of time of a substantially periodic movement of the region of the body.

A method of this kind is known from the "Book of Abstracts" of the Fourth Annual Meeting, Society of Magnetic Resonance in Medicine, London 1985, page 1064, which contains an abstract of a paper prescuted by M. Yamashita and T. Maki on 22nd August 1985 in London.

Devices for determining a nuclear magnetization distribution in a region of a body and the principles of their operation are known, for example from the article "Proton NMR Tomography" in Philips Technical Review, Volume 41, 1983/84, No. 3,pp 73-88. For an explanation of their construction and principles of operation, reference is made to that article.

In a method as disclosed in the abstract of the paper by M. Yamashita and T. Maki a so-called spin warp measurement is performed which, however, is not described in detail. Briefly speaking, during a spin-warp measurement a body to be examined is exposed to a steady, uniform magnetic field $B_0$, the di-

rection of which coincides with, for example the z-axis of a cartesian (x, y, z) system of coordinates. The steady magnetic field $B_0$ causes a slight polarization of the spins present in the body and enables a precessional motion of the spins about the direction of the magnetic field $B_0$. After application of the magnetic field $B_0$, a magnetic field gradient $G_z$ which acts as a selection gradient for a slice to be selected is applied and at the same time a 90° r.f. pulse is excited which rotates the magnetization direction of the nuclei present in a selected region of the body through an angle of 90°. After termination of the 90° pulse, the spins will perform a precessional motion about the field direction of the magnetic field $B_0$ and will generate a resonance signal (FID free induction decay signal). After the 90° pulse there are applied field gradients $G_y$, $G_x$ and $G_z$, the field direction of which coincides with that of the magnetic field $B_0$ and the gradient directions of which extend in the x, the y and the z-direction, respectively. The field gradients $G_z$ and $G_y$ serve for rephasing in the z-direction and phase encoding (spin warp) - also referred to as "preparation" - of the spins in the y-direction, respectively. After termination of these three field gradients, the magnetic field gradient $G_x$ is applied again in order to excite an echo resonance signal. This echo signal of said FID signal is subsequently sampled in order to obtain information in the x-direction. In order to obtain an image of a selected region, the above measurement is repeated a number of times, taking in each cycle a different value for the time integral of the preparation gradient $G_y$. By arranging the echo resonance signals in order of increasing magnitude of the time integral of the preparation gradient $G_y$ and by subjecting the information obtained in the x-direction and the y-direction to a two-dimensional Fourier transformation, a spin density distribution will be obtained as a function of x and y in the slice selected by means of $G_z$. A three-dimensional spin density distribution can be obtained in a similar manner.

In the abstract it is remarked that an image thus obtained contains disturbing artefacts due to, for example breathing, cardiac or stomach movements of a patient under examination. These movements exhibit a substantial periodicity. To avoid movement artefacts, often referred to as blurring and ghosting, the article suggests to concentrate all measurements at a limited number of instants, for example four, with respect to a reference point of time of the periodic movement and to arrange the measurements in order of increasing magnitude of the time integral of the preparation gradient. A movement with a period of from 4 to 8 second then seems to have an effective period of many hundreds of seconds.

It is a drawback of the known method that the images obtained still contain unacceptable movement artefacts, in that no continuous relation is achieved between the instant of movement with respect to a reference point of time and the integral of the intensity over the duration of the preparation magnetic field gradient.

It is the object of the invention to provide a method and a device with which MRI images can be achieved that are substantially free from movement artefacts.

To achieve this, a method of the kind set forth in accordance with the invention is characterized as in claim 1. To this end, the starting instant of the measurements of the spin resonance signal is shifted in time with respect to the reference point of time in successive periods of the periodic movement. A smooth relation is thus realized between the instant of movement with respect to the reference point of time and the integral of the intensity over the duration of the preparation magnetic field gradient, so that it seems as if the movement of the body is only slow and smooth in relation to the breathing movement. Movement artefacts in an image reconstructed from the spin resonance signals are thus substantially reduced.

One version of a method in accordance with the invention is characterized in that during a number of periods of said periodic movement a number of measurements are performed at substantially equidistant instants during each period. The method can thus be efficiently programmed in computer means and the execution of the method by means of programmed computer means will require only a comparatively short period of time.

A further version of a method in accordance with the invention is characterized in that the time intervals between said equidistant instants are adapted to any variations of the duration of the period. The method is thus adapted to a slow variation of the breathing frequency. The starting of, for example the first and the last measurements within a breathing period can be adapted to the changed breathing period.

Another version of a method in accordance with the invention is characterized in that said instants are monotonously shifted in time with respect to the reference point of time in each subsequent period of the periodic movement. The efficiency of the programmed computer means is thus further enhanced, notably when the shift takes place over the same unit of time.

A further version yet of a method in accordance with the invention is characterized in that measurements performed during a period having a deviation duration are repeated during a next period. Resonance signals excited during a breathing period whose duration deviates substantially (for whatever reason) from the breathing rhythm during measurement generally will not be processed. As a result, not all information would become available for filling up the image frequency space. In order to eliminate this drawback, this information is collected by repeating the measurement during a next period.

Yet another version of a method in accordance with the invention is characterized in that measurements of another measurement cycle are performed at intermediate instants. During measurements in a selected slice, there will generally be sufficient time left for performing measurements in other selected slices at intermediate instants. Quasi-simultaneous measurement then takes place in different slices (multi-slice imaging). The method in accordance with the invention also utilizes this measurement procedure, the method being applied with a shift of the starting instant in each slice.

A device in accordance with the invention is characterized as in claim 7.

An embodiment of a device in accordance with the invention is characterized in that the device includes means for determining the time shift of said periodic movement.

A further embodiment of a device in accordance with the invention is characterized in that the device includes means for regulating said periodic movement. Using light signals and/or sound signals, a patient under examination can be instructed to start breathing more slowly or faster in order to obtain a breathing rhythm which is as constant as possible.

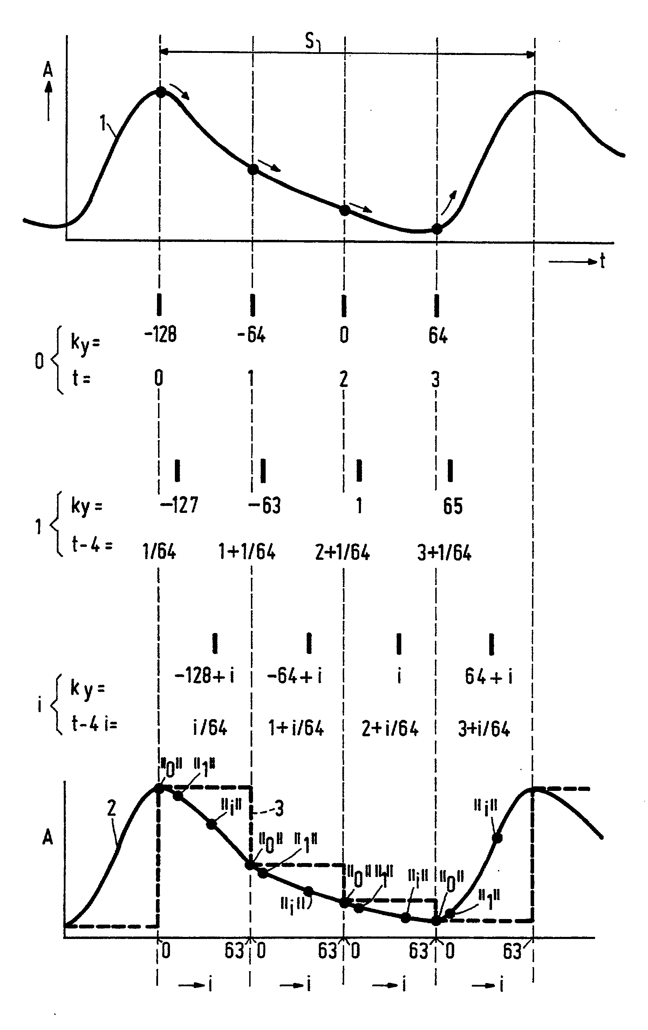

The invention will be described in detail hereinafter with reference to the accompanying drawing which shows diagrammatically a breathing cycle and the measurement instants for a version of a method in accordance with the invention.

The drawing shows a breathing cycle 1 have a period S of approximately 4 seconds, the amplitude A of the respiration being plotted along the vertical axis and the time t along the horizontal axis. For simplicity, the figure shows one period of the breathing cycle and the measurements performed in the successive periods are placed one below the other. In each breathing cycle four measurements are performed with a repetition time of approximately 1 second. The value of the time integral of the magnetic preparation gradient is denoted by the reference $k_y$ and covers the range from -128 to +128 in arbitrary units. During a first period of the breathing cycle 1, denoted by the sequence number 0 in the left-hand column, four measurements are performed at the instants t=0, t-1, t=2 and t=3 seconds, using values of the time integral of the magnetic preparation gradient of $k_y = -128$, $k_y = -64$, $k_y = 0$ and $k_y = 64$, respectively.

During the second period of the breathing cycle 1, denoted by the sequence number 1 in the left-hand column, the instants are shifted 1/64 second in time with respect to the starting instant t-4 of this second period, and the respective values $k_y$ of the magnetic preparation gradient are increased by an amount 1. This means that at the instants t-4 = 1/64, t-4 = 1+1/64, t-4 = 2+1/64 and t-4 = 3+1/64 seconds magnetic preparation gradients are applied with $k_y = -127$, $k_y = -63$, $k_y = -1$ and $k_y = 65$, respectively.

Therefore, during the $i^{th}$ period the measurement instants have generally been shifted i/64 second in time with respect to the starting instant t-4i of the $i^{th}$ period, and the measurement instants are t-4i = i/64, t-4i = 1+i/64, t-4i = 2+i/64 and t-4i = 3+i/64, and the respective values of the preparation gradient are $k_y = -128+i$, $k_y = -64+i$, $k_y = i$ and $k_y = 64+i$.

The measurement has been completed when i has assumed all values between 0 and 63, i.e. after 64 breathing periods. The sequence in which i assumed the values between 0 and 63 is of minor importance and, moreover, some measurements may also have failed. Failed measurements can be repeated, while maintaining the described principle, during another period. Furthermore, $k_y$ need not necessarily increase as i increases, but may also decrease as i increases.

The lower part of the figure shows the apparent breathing cycle 2 as a function of the value of $k_y$ obtained by means of a method in accordance with the invention. It seems as if all measurements are regularly distributed over one breathing period. Without the described time shift of 1/64 second for an increase of i by 1, a stepped apparent breathing period would be obtained as denoted in the figure by a broken line 3 and already known from the cited paper by M. Yamashita and T. Maki.

When the breathing frequency varies, the measurement instants are adapted to the changed period duration, i.e. made earlier or later. The period of time elapsing between the measurement cycles of a breathing cycle can be used to perform, in accordance with an analogous procedure, measurements which relate to a region of the body other than the region whereto the above measurement cycles are related. This is also referred to as multiple slice imaging.

**Claims**

1. A method of determining a nuclear magnetization distribution in a region of a body which is situated in a steady, uniform magnetic field and in which a spin resonance signal is generated by means of an r.f. electromagnetic pulse, the spin resonance signal being prepared by means of a magnetic preparation gradient superimpose on the uniform magnetic field and being measured by means of a magnetic measurement gradient superimposed on the uniform magnetic field, which measurement is repeated a number of times using different, predetermined values of the time integral of the preparation gradient, predetermined values of the time integral being used for predetermined time shifts with respect to a reference point of time of a substantially periodic movement of the region of the body, characterized in that in order to reduce artifacts in the nuclear magnetization distribution extra time shifts are applied to said predetermined time shifts in successive movement cycles, for each resultant time shift with respect to the reference point of time the value of said time integral being proportional to the respective resultant time shifts.

2. A method as claimed in Claim 1, characterized in that during a number of periods of said periodic movement a number of measurements are performed at substantially equidistant instants during each period.

3. A method as claimed in Claim 2, characterized in that the time intervals between said equidistant instants are adapted to any variations of the duration of the period.

4. A method as claimed in Claim 2 or 3, characterized in that said instants are monotonously shifted in time with respect to the reference point of time in each subsequent period of the periodic movement.

5. A method as claimed in Claim 1, 2, 3 or 4, characterized in that measurements performed during a period having a deviating duration are repeated during a next period.

6. A method as claimed in Claim 1, 2, 3, 4 or 5, characterized in that measurements of another measurement cycle are performed at intermediate instants.

7. A device for determining a nuclear magnetization distribution in a region of a body, which device comprises:

a) means for applying a steady, uniform field,

b) means for exciting an r.f. electromagnetic pulse,

c) means for applying a magnetic preparation gradient field during a preparation period,

d) means for applying a magnetic measurement gradient field during a measurement period,

e) sampling means for sampling, during the measurement period, a resonance signal excited by the r.f. electromagnetic pulse.

f) processing means for processing the signals supplied by the sampling means, and

g) control means for controlling said means in the paragraphs b) up to and including f), the control means supplying said means in paragraph c) with control signals for adjusting the time integral of the magnetic preparation gradient, predetermined values of the time integral being used for predetermined time shifts with respect to a reference point of time of a substantially periodic movement of the region of the body,

characterized in that the device includes means for applying extra time shifts said predetermined time shifts in successive movement cycles, and for rendering the value of said time integral substantially proportional to the time shift with respect to the reference instant of said periodic movement at the instant of application of the preparation gradient.

8. A device as claimed in Claim 7, characterized in that the device includes means for determining the time shift of said periodic movement.

9. A device as claimed in Claim 7 or 8, characterized in that the device includes means for regulating said periodic movement.

**Patentansprüche**

1. Verfahren zum Bestimmen einer Kernspinresonanzverteilung in einem Gebiet eines Körpers, der sich in einem statischen, einheitlichen Magnetfeld befindet und in dem mit Hilfe eines elektromagnetischen Hf-Impulses ein Kernspinresonanzsignal erzeugt wird, das mittels eines dem einheitlichen Magnetfeld überlagerten, magnetischen Vorbereitungsgradienten vorbereitet und mittels eines dem einheitlichen Magnetfeld überlagerten magnetischen Meßgradienten gemessen wird, wobei diese Messung einige Male unter Verwendung verschiedener vorgegebener Werte des Zeitintegrals des Vorbereitungsgradienten wiederholt wird, wobei vorgegebene Werte des Zeitintegrals für vorgegebene Zeitverschiebungen in bezug auf einen Bezugszeitpunkt einer im wesentlichen periodischen Bewegung des Gebiets des Körpers benutzt werden, dadurch gekennzeichnet, daß zum Verringern von Artefakten in der Kernspinresonanzverteilung in aufeinanderfolgenden Bewegungszyklen die vorgegebenen Zeitverschiebungen mit zusätzlichen Zeitverschiebungen ergänzt werden, wobei für jede vorgefundene Zeitverschiebung in bezug auf den Bezugszeitpunkt der Wert des Zeitintegrals den jeweiligen resultierenden Zeitverschiebungen proportional ist.

2. Verfahren nach Anspruch 1, dadurch gekennzeichnet, daß in einer Anzahl von Perioden der periodischen Bewegung eine Anzahl von Messungen zu im wesentlichen äquidistanten Zeitpunkten in jeder Periode ausgeführt wird.

3. Verfahren nach Anspruch 2, dadurch gekennzeichnet, daß die Zeitintervalle zwischen den äquidistanten Zeitpunkten an Schwankung in der Periodendauer angepaßt werden.

4. Verfahren nach Anspruch 2 oder 3, dadurch gekennzeichnet, daß die Zeitpunkte in bezug auf den Bezugszeitpunkt in jeder auffolgenden Periode der periodischen Bewegung zeitlich moton verschoben werden.

5. Verfahren nach Anspruch 1, 2, 3 oder 4, dadurch gekennzeichnet, daß in dieser Periode ausgeführte Messungen mit einer abweichenden Dauer in einer folgenden Periode wiederholt werden.

6. Verfahren nach Anspruch 1, 2, 3, 4 oder 5, dadurch gekennzeichnet, daß Messungen eines anderen Meßzyklus zu zwischenliegenden Zeitpunkten ausgeführt werden.

7. Gerät zum Bestimmen einer Kernspinresonanzverteilung in einem Gebiet eines Körpers, und dieses Gerät enthält folgende Elemente:

a) Mittel zum Anlegen eines statischen, einheitlichen Feldes,

b) Mittel zum Anregen eines elektromagnetischen Hf-Impulses,

c) Mittel zum Anlegen eines magnetischen Vorbereitungs-Gradientenfeldes für die Dauer einer Vorbereitungszeit,

d) Mittel zum Anlegen eines magnetischen Vorbereitungs-Gradientenfeldes für die Dauer einer Meßzeit,

e) Abtastmittel zum Abtasten eines vom elektromagnetischen Hf-Impuls angeregten Resonanzsignals,

f) Bearbeitungsmittel zum Bearbeiten der von den Abtastmitteln gelieferten Signale, und

g) Steuermittel zum Steuern der unter b) bis einschl. f) genannten Mittel, wobei die Steuermittel zum Einstellen des Zeitintegrals des magnetischen Vorbereitungsgradienten die unter c) genannten Mittel mit Steuersignalen, wobei die vorgegebenen Werte des Zeitintegrals für vorgegebene Zeitverschiebungen in bezug auf eine im wesentlichen periodische Bewegung des Gebiets des Körpers benutzt werden,

dadurch gekennzeichnet, daß das Gerät Mittel zum Ergänzen der vorgegebenen Zeitverschiebungen mit zusätzlichen Zeitverschiebungen in aufeinanderfolgende Bewegungszyklen und zum im wesentlichen proportionalen Angleichen des Wertes des Zeitintegrals an die jeweils vorgefundenen Zeitverschiebungen in bezug auf den Bezugszeitpunkt der periodischen Bewegung zum Zeitpunkt des Anlegens des Vorbereitungsgradienten enthält.

8. Gerät nach Anspruch 7, dadurch gekennzeichnet, daß dieses Gerät Mittel zum Bestimmen der Zeitverschiebung der periodischen Bewegung enthält.

9. Gerät nach Anspruch 7 oder 8, dadurch gekennzeichnet, daß dieses Gerät Mittel zum Regeln der periodischen Bewegung enthält.

**Revendications**

1. Procédé pour déterminer une distribution de magnétisation nucléaire dans une région d'un corps qui est située dans un champ magnétique uniforme constant et dans laquelle un signal de résonance de spin est engendré à l'aide d'une impulsion électromagnétique r.f., le signal de résonance de spin étant préparé à l'aide d'un gradient de préparation magnétique superposé au champ magnétique uniforme et étant mesuré à l'aide d'un gradient de mesure magnétique superposé au champ magnétique uniforme, cette mesure étant répétée un certain nombre de fois l'aide de différentes valeurs prédéterminées pour l'intégrale de temps du gradient de préparation, des valeurs prédéterminées de l'intégrale de temps étant utilisées pour des décalages de temps prédéterminés par rapport à un point de référence de temps d'un mouvement en substance périodique de la région du corps, caractérisé en ce que pour réduire les artefacts dans la distribution de magnétisation nucléaire, des décalages de temps supplémentaires sont appliqués auxdits décalages de temps prédéterminés dans des cycles de mouvement successifs, la valeur de l'intégrale de temps étant, pour chaque décalage de temps par rapport au point de référence de temps qui en résulte, proportionnelle aux décalages de temps résultants respectifs.

2. Procédé suivant la revendication 1, caractérisé en ce que pendant un certain nombre de périodes du mouvement périodique, un certain nombre de mesures sont exécutées à des instants en substance équidistants pendant chaque période.

3. Procédé suivant la revendication 2, caractérisé en ce que les intervalles de temps s'écoulant entre les instants équidistants sont adaptés à toutes les variations de la durée de la période.

4. Procédé suivant la revendication 2 ou 3, caractérisé en ce que les instants subissent un décalage monotone dans le temps par rapport au point de référence de temps dans chaque période suivante du mouvement périodique.

5. Procédé suivant la revendication 1, 2, 3 ou 4, caractérisé en ce que des mesures exécutées pendant une période ayant une durée différente sont répétées pendant une période suivante.

6. Procédé suivant la revendication 1, 2, 3, 4 ou 5, caractérisé en ce que des mesures d'un autre cycle de mesure sont exécutées à des instants intermédiaires.

7. Dispositif servant à déterminer une distribution de magnétisation nucléaire dans une région d'un corps, ce dispositif comprenant:

a) des moyens pour appliquer un champ magnétique uniforme constant,

b) des moyens pour exciter une impulsion électromagnétique r.f.,

c) des moyens pour appliquer un champ de gradient de préparation magnétique pendant une période de préparation,

d) des moyens pour appliquer le champ de gradient de mesure magnétique pendant une période de mesure,

e) des moyens d'échantillonnage pour échantillonner, pendant la période de mesure, un signal de résonance excité par l'impulsion électromagnétique r.f.,

f) des moyens de traitement pour traiter les signaux fournis par les moyens d'échantillonnage, et

g) des moyens de commande pour commander les moyens cités dans les paragraphes b) à f) inclus, les moyens de commande fournissant aux moyens du paragraphe c) des signaux de temps du gradient de préparation magnétique, des valeurs prédéterminées de l'intervalle de temps étant utilisées pour des décalages de temps prédéterminés par rapport à un point de référence de temps d'un mouvement en sustance périodique de la région du corps, caractérisé en ce qu'il comprend des moyens pour appliquer des décalages de temps suplémentaires aux décalages de temps prédétermines dans des cycles de mouvement successifs et pour rendre la valeur de cette intégrale de temps en substance proportionelle aux décalages de temps résultants respectifs par rapport à l'instant de référence du mouvement périodique à l'instant de l'application du gradient de préparation.

8. Dispositif suivant la revendication 7, caractérisé en ce qu'il comprend des moyens pour déterminer le décalage de temps du mouvement périodique.

9. Dispositif suivant la revendication 7 ou 8, caractérisé en ce qu'il comprend des moyens pour régler le mouvement périodique.

EP 0 228 129 B1